# EUROPEAN PATENT APPLICATION

(11) **EP 0 723 201 A1**
(43) Date of publication of application: **24.07.1996**
(21) Application number: 96300234.0
(22) Date of filing: 11.01.1996
(51) Int. Cl.: G03F 7/004, C08F 212/14

(54) **Phenolic-resins with acid-labile protecting groups**

(30) Priority: 20.01.1995 CH 166/95
(71) Applicant: OCG MICROELECTRONIC MATERIALS, INC., Cheshire, Connecticut 06410-0586 (US)
(72) Inventor: Schulz, Reinhard, D-79219 Staufen-Wettelbrunn (DE); Mertesdorf, Carl-Lorenz, D-79189 Bad Krozingen (DE); Schacht, Hans-Thomas, D-79618 Rheinfelden (DE); Muenzel, Norbert, D-79423 Heltersheim (DE); Holzwarth, Heinz, D-79189 Bad Krozingen (DE); Falcigno, Pasquale Alfred, CH-4052 Basle (CH)
(74) Representative: Baker, Colin John

(57) **Abstract**

A phenolic resin in which 10-90% of the phenolic hydroxyl groups are replaced by protective groups of the formula I: 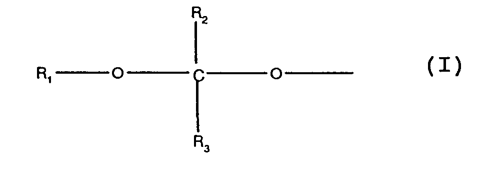
in which R₁ and R₂ are each independently of the other are C₁-C₆alkyl, C₃-C₆cycloalkyl which is unsubstituted or is substituted by one or more C₁-C₄alkyl groups, or are -(CH₂)ₙ-aryl, or R₁ or R₂, together with the oxygen and carbon atoms attached to these radicals, form a five- to eight-membered ring which may contain, as ring members, further heteroatoms or hetero-groups such as -O-, -S-, -SO₂-or -NR₈-, where R₈ is C₁-C₆alkyl, aryl or C₆-C₁₆arayl, R₃ is hydrogen, C₁-C₆alkyl, C₃-C₆cycloalkyl which is unsubstituted or is substituted by one or more C₁-C₄alkyl groups or is -(CH₂)ₙ-aryl, or R₂ and R₃, together with the carbon atom attached to these radicals, form a five- to eight-membered ring which may contain, as ring members, further heteroatoms or hetero-groups such as -O-, -S-, -SO₂- or -NR₈-, where R₈ is C₁-C₆alkyl, aryl or C₆-C₁₆aralkyl, n is 0, 1, 2 or 3 and aryl is naphthyl or phenyl which is substituted by one or more C₁-C₄alkyl, C₁-C₄alkoxy, nitro or cyano groups or halogen atoms, with the proviso that the ratio of the weight-average to the number-average molecular weight, M_{w}/Mₙ, is in the range 1.03-1.80 has high thermal stability and is suitable as a binder for resist compositions of high processing stability and flow resistance.

## Description

### BACKGROUND OF THE INVENTION

### 1. Field of the Invention

The present invention relates to phenolic resins having a narrow, virtually monodispersed molecular weight distribution and with acid-labile acetal and ketal side groups, to radiation-sensitive compositions comprising these phenolic resins, to processes for the production of images using these compositions, and to the use of the polymers in positive photoresists.

### 2. Brief Description of the Relevant Art

The production of highly integrated circuits currently requires the ability for structures having a width of less than 0.35 µm to be transferred imagewise to the substrate. The resolution capacity, for example of an o-quinone diazide/novolak system, has reached the limits of the physically possible at a wavelength of 365 nm, which is used for the imagewise exposure. For this reason, there is increasing interest in photoresists which work at shorter wavelengths in the deep UV region (DUN region, deep ultra violet: 200 to 300 nm). Novolaks absorb so strongly in this region that uniform exposure over the usual layer thickness of approximately 1.0 µm is impossible. In order to ensure the requisite optical transparency, poly(p-hydroxystyrene) or derivatives thereof are generally used as binder resins for photoresists working in the DUV region.

As is generally known, systems of increased radiation sensitivity comprise, for example, alkali-soluble binder resins whose alkali-solubilizing groups, for example hydroxyl groups, are blocked by acid-labile protective groups, thus rendering the binder resin substantially insoluble in alkali. Exposure then initiates a primary reaction of an acid photogenerator which absorbs at the appropriate wavelength, forming a strong acid which, in the subsequent secondary reaction, results in elimination of the protective groups and thus in reformation of the solubilizing groups.

An example which may be mentioned of such systems is poly(p-hydroxystyrene), whose phenol groups are protected by, for example, tert-butyloxycarbonyloxy (TBOC) or tetrahydropyranyl (THP) groups. Photoresists comprising such binder resins are known (see for example: M.J. Bowden and S.R. Turner (eds.) "Electronic and Photonic Application of Polymers", ACS Series 218, Washington 1988; and N. Hayashi et al., Polymer 33, 1583 (1992)), but have disadvantages with respect to adhesion to silicon.

Furthermore, these chemically reinforced positive resists are very sensitive with respect to the process interval between the primary reaction and the subsequent secondary reaction. Extended intervals (post exposure delay), which become critical after only a few minutes in sensitive systems, result in considerable surface inhibition, leading to the formation of T-shaped denatured profiles (S.A. MacDonald et al., SPIE Vol. 1466, Advances in Resist Technology and Processing VIII (1991) 2-7).

Attempts have been made to improve adhesion, reproducibility and resolution in the resist formulations by using therein a binder resin whose phenolic hydroxyl groups have been replaced only partially by acid-cleavable protecting groups. One example of such attempts is EP-A-447,868, which proposes a radiation-sensitive mixture in which the phenolic resin is protected partially by tetrahydropyranyl groups.

EP A 520 642 proposes poly(hydroxystyrene) polymers protected partially by acetal or ketal groups, which polymers are claimed to be likewise unhindered by the abovementioned disadvantages. It is known, however, that copolymers having free phenolic monomer units are increasingly subject to losses in thermostability. Thermally induced decomposition (autocatalysis) can be attributed to a partial deprotection which results from the catalytic effect of the weakly acidic, phenolic hydroxyl groups. With the resists of the prior art it has not been possible to solve this problem satisfactorily, especially in the case of highly acid-labile protective groups such as the acetal and ketal protective groups. It is precisely these protective groups, however, which are preferred, since they permit a relatively long interval between exposure and post-exposure bake (and thus a greater scope in processing) than the less acid-labile protecting groups, for example the tert-butoxycarbonyloxy (TBOC) group or the tert-butyl ester protective group.

An important factor for the thermal flow resistance of the relief structures produced is the level of the glass transition temperature (T_{g}) of the binder resin. As the content of protecting groups increases, there is a decrease in T_{g} and consequently in the flow resistance of the resist structures as well. A sufficiently high flow resistance (dimensional stability of the resist structures produced), however, is of fundamental importance for the plasma-chemical structure transfer (etching process) on the semiconductor substrate (TiN, SiO₂, Al, etc.) subsequent to the lithographic process.

### BRIEF SUMMARY OF THE INVENTION

The object of the present invention is to develop novel polymers, and positive-working, highly active, radiation-sensitive systems resulting therefrom, especially for the production of relief structures, which polymers do not have the abovementioned disadvantages; in other words, they should in particular have good adhesion and processing stability, be sensitive to UV radiation, electron beams and X-rays and should be particularly suitable for use in the DUV region owning to their high optical transparency, and still further should possess good thermal stability and permit high resolution.

It has surprisingly been found that radiation--sensitive mixtures comprising a phenolic resin having a narrow, virtually monodisperse molecular weight distribution, in which some of the phenolic OH groups have been replaced by acetal or ketal protecting groups, do not have the above-described disadvantages.

The present invention relates to a phenolic resin in which 10-90% of the phenolic hydroxyl groups are replaced by protective groups of the formula I: 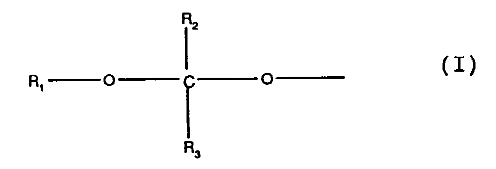 in which R₁ and R₂ are each independently of the other C₁-C₆alkyl, C₃-C₆cycloalkyl which is unsubstituted or is substituted by one or more C₁-C₄alkyl groups, or are -(CH₂)ₙ-aryl, or R₁ and R₂, together with the oxygen and carbon atoms attached to these radicals, form a five- to eight-membered ring which may contain, as ring members, further heteroatoms or hetero-groups such as -O-, -S-, -SO₂- or -NR₈-, where R₈ is C₁-C₆alkyl, aryl or C₆-C₁₆aralkyl, R₃ is hydrogen, C₁-C₆alkyl, C₃-C₆cycloalkyl which is unsubstituted or is substituted by one or more C₁-C₄alkyl groups, or is -(CH₂)ₙ-aryl, or R₂ and R₃, together with the carbon atom attached to these radicals, form a five- to eight-membered ring which may contain, as ring members, further heteroatoms or hetero-groups such as -O-, -S-, -SO₂- or -NR₈-, where R₈ is C₁-C₆alkyl, aryl or C₆-C₁₆aralkyl, n is 0, 1, 2 or 3 and aryl is naphthyl or phenyl which is substituted by one or more C₁-C₄alkyl, C₁-C₄alkoxy, nitro or cyano groups or halogen atoms, with the proviso that the ratio of the weight-average to the number-average molecular weight, M_{w}/Mₙ, is in the range 1.03-1.80.

### DETAILED DESCRIPTION OF PREFERRED EMBODIMENTS

Preferred phenolic resins are those containing structural repeating units of the formulae II and III: 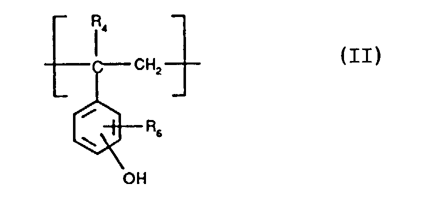 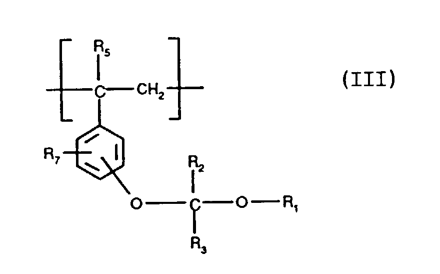 in which R₁, R₂ and R₃ are as defined above and R₄ and R₅ are each independently of the other hydrogen, methyl or halogen, and R₆ and R₇ are each independently of the other hydrogen, C₁-C₄alkyl, C₁-C₄alkoxy or halogen.

Particularly preferred phenolic resins are those containing structural repeating units of the formulae IIa and IIIa: 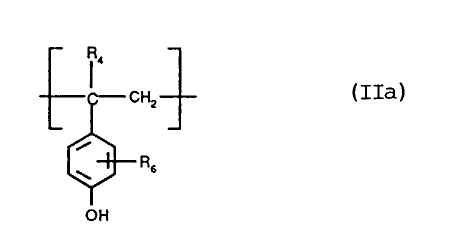 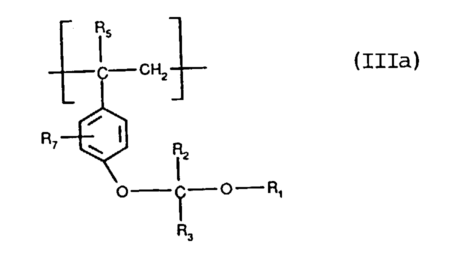 in which R₁ to R₇ are as defined above.

Alkyl group substituents R₁ to R₈ can be linear or branched. Examples are methyl, ethyl, n-propyl, isopropyl, n-butyl, sec-butyl, isobutyl, tert-butyl, n-pentyl, neo-pentyl, isopentyl, n-hexyl and isohexyl.

Examples of alkoxy substituents are methoxy, ethoxy, n-propoxy, isopropoxy, n-butoxy and tert-butoxy.

Halogen substituents R₄ to R₇ are preferably fluoro, bromo and, in particular, chloro.

Aralkyl groups are preferably benzyl or phenylethyl.

In the structural units of the formulae II and III, R₄, R₅, R₆ and R₇ are preferably hydrogen.

A particularly preferred phenolic resin is one comprising structural repeating units of the formulae II and III, in which R₁ and R₂ are each independently of the other methyl, ethyl, n-propyl, isopropyl, n-butyl, isobutyl, tert-butyl or cyclohexyl or R₁ and R₂, together with the oxygen and carbon atoms attached to these radicals, form a tetrahydrofuryl or tetrahydropyranyl ring.

In the structural units of the formulae II and III, R₃ is preferably hydrogen or methyl.

In the phenolic resins according to the invention, 15-70% of the phenolic hydroxyl groups are preferably replaced by protective groups of the formula I.

The preferred ratio of the weight-average to the number-average molecular weight, M_{w}/Mₙ, is 1.03-1.5.

The phenolic resins according to the invention can be obtained, for example, by subsequently protecting alkali-soluble resins containing phenolic groups with vinyl ether compounds or isopropenyl ether compounds, for example with methyl vinyl ether, ethyl vinyl ether, n-butyl vinyl ether, tert-butyl vinyl ether, cyclohexyl vinyl ether, isopropyl vinyl ether, dihydrofuran, dihydropyran, 2-methoxypropene and the like, by known methods. Protection is preferably effected in the presence of a suitable, usually acidic, catalyst. Examples of such suitable catalysts are acidic ion exchange resins, acids, for example hydrochloric acid, sulfonic acids, or salts thereof, for example pyridinium tosylate.

Suitable alkali-soluble resins containing phenolic hydroxyl groups are homopolymers, for example poly(4-hydroxystyrene), poly(4-hydroxy-α-methylstyrene), poly(3-hydroxystyrene) or copolymers formed from phenolic vinyl monomers and other monomer units, such as reaction products of 4-hydroxystyrene, 3-hydroxystyrene, acrylic acid, methacrylic acid, alkyl methacrylate, alkyl acrylate, styrene, fumaronitrile, maleic anhydride or maleiimide and derivatives thereof.

The alkali-soluble phenolic resins can be obtained by known methods by appropriate polymerization or copolymerization of the monomers and can subsequently be modified. Examples of such modifications are the partial hydrogenation of the phenolic groups to give cyclohexanol groups, or the partial substitution or derivatization of the phenolic OH groups, for example by esterification or etherification.

It is possible to choose polymerization methods which lead direct to a narrow molecular weight distribution, such as anionic polymerization, or this narrow molecular weight distribution can be obtained by fractionation or by suitable combination of such methods.

As indicated at the outset, the phenolic resins according to the invention are used in positive resist formulations for electronics (electroplating resists, etch resists and solder resists), for mould etching, in the production of printing plates, such as offset printing plates or screen printing formes, and printed circuits and, in particular, in microelectronics for the fabrication of integrated circuits.

The invention thus also relates to a radiation-sensitive composition comprising, based on the total amount of components (A) and (B),
(A) 80.0-99.9% by weight, preferably 90-99.8% by weight, of a phenolic resin according to the invention and
(B) 0.1-20.0% by weight, preferably 0.2-10% by weight, of a substance which generates an acid on exposure to actinic radiation.

The polymers of component (A) contain acetal or ketal protecting groups which are eliminated by acid catalysis, so that the solubility of the mixture in an aqueous-alkaline solution is increased. Furthermore, these mixtures are distinguished in particular by high thermal stability, and they have a long shelf life, a high resolution capacity and good adhesion.

The radiation-sensitive components (B) which generate acids on exposure to actinic radiation can be any of a large number of known compounds. These include, for example, the diazonium salts used in the diazotype process, the o-quinone diazides used in known positive-working copying compositions, or halogen compounds which form a hydrohalic acid on irradiation. Compounds of this type are described, for example, in US-A 3,515,552, 3,536,489 or 3,779,778 and in DE-A 27 18 259, 22 43 621 or 26 10 842.

Suitable radiation-sensitive components (B) of the composition according to the invention are in particular cationic photoinitiators selected from the group consisting of iodonium and sulfonium salts. Such compounds are described, for example, in "UV-curing, Science and Technology" (Editor: S.P. Pappas, Technology Marketing Corp., 642 Westover Road, Stamford, Connecticut, USA).

It is also possible to use sulfoxonium salts as radiation-sensitive compounds. Such salts are described, for example, in EP-B 35,969 and EP-A 44,274 and 54,509. Particular mention should be made of aliphatic sulfoxonium salts which absorb in the deep UV region.

It is also possible to employ sulfonic acid esters as described, for example, in US 5,118,582, US 5,189,402 and in T. Ueno et al., Polym. Eng. Sci. 32, 1511 (1992). Also suitable are other sulfonic acid esters, for example N-sulfonyloxyimides, as described in EP-A 502,677, and the nitrobenzyl sulfonates described in US 5,135,838, for example 2-nitro-6-trifluoromethylbenzyl 4-methoxybenzenesulfonate. Other sulfonyl compounds which can be used are described in, for example DE-A 42 25 422 and in Polym. Eng. Sci. 32, 1476 (1992).

Particularly preferred for irradiation with short-wave UV rays or electron beams are disulfonic compounds, for example the phenyl cumyl disulfone and phenyl 4-anisyl disulfone described in DE 38 04 316.

The imino sulfonates described, inter alia, in EP-A 241,423 and EP-A 571,330, are also particularly suitable.

It is also possible to use compounds which generate sulfonic acids on irradiation with actinic light. Such compounds are known per se and are described, for example, in GB-A 2,120,263, in EP-A 84 515, 37,152 or 58,638 and in US-A 4,258,121 or 4,371,605. Compounds which generate carboxylic acid on irradiation can likewise be used. Such compounds are described in EP-A 552,548, for example.

If salts are used as the radiation-sensitive acid-generating compounds (B), said salts are preferably soluble in organic solvents. Most preferably, these salts are products with complex acids, for example tetrafluoroboric acid, hexafluorophosphoric acid, trifluoromethanesulfonic acid, hexafluoroarsenic acid or hexafluoroantimonic acid.

The compositions according to the invention preferably contain as component (B) a disulfone or a sulfonic acid ester.

Also preferred are radiation-sensitive compositions comprising in addition to components (A) and (B) an organic solvent as component (C).

The choice of organic solvent as component (C) and its concentration depend principally on the nature of the composition of the resist formulation and on the coating method. The solvent should be inert, i.e. it should not undergo any chemical reaction with components (A) and (B) and it should be removable again on drying after coating. Examples of suitable solvents are ketones, ethers, esters and aromatic compounds, and any mixtures thereof. Examples of such solvents are methyl ethyl ketone, isobutyl methyl ketone, cyclopentanone, cyclohexanone, N-methylpyrrolidone, dioxane, tetrahydrofuran, 2-methoxyethanol, 2-ethoxyethanol; acetates, such as butyl acetate; 1-methoxy-2-propanol, 1,2-dimethoxyethane, diethylene glycol dimethyl ether, butyl glycol, alkylene glycol monoalkyl ethers, for example ethylcellosolve, ethylene glycol monobutyl ether and methylcellosolve; alkylene glycol alkyl ether esters, such as methylcellosolve acetate, ethylcellosolve acetate, propylene glycol ethyl ether acetate and methoxypropyl acetate; ethyl acetate, n-butyl acetate, ethyl 3-ethoxypropionate and methoxymethyl propionate, ethyl lactate, toluene and xylenes. Preferred organic solvents are ethyl lactate, ethoxyethyl propionate and, in particular, methoxypropyl acetate.

Preference is likewise given to compositions comprising, based on the total amount of components (A) and (B), from 0.01 to 40% by weight of customary additives in addition as component (D).

These customary additives are, for example, the following substances:

Pigments or dyes in amounts of about 0.1 to 2% by weight, based on the total amount of components (A) and (B), for instance Mikrolith Blau 4G, Orasolblau GN and Irgalithgrun.

Organic and inorganic fillers in quantities of from about 5 to 15% by weight, based on the overall quantity of components (A) and (B), such as talc, quartz (SIO₂), barium sulfate (BaSO₄), aluminum oxide and calcium carbonates, with which it is possible for example to enhance the properties of a coating, such as heat resistance, adhesion or scratch resistance.

Weakly basic additives (coating additives) in a total amount of about 0.01 to 10% by weight, based on the total amount of components (A) and (B), such as antifoams (for example Byk 80), adhesion promoters (for example benzotriazole), fungicides and thixotropic agents or hydroxyl-terminated polyglycol ethers containing ethylene oxide and/or propylene oxide units, for example, Tetronic 701, 901, 908P and 1501 (BASF products).

Surfactants for improving the wetability of the composition, for preventing striation on the resulting film, for improving the developability of the irradiated area, etc. These surfactants include nonionic surfactants, for example polyoxyethylene lauryl ether, polyoxyethylene stearyl ether, polyoxyethylene oleyl ether, polyoxyethylene octylphenol ether, polyoxyethylene nonylphenol ether, polyoxyethylene glycol dilaurate and polyethylene glycol distearate; fluorinated surfactants, for example F Top EF 301, EF 303 and EF 352 (products of Shin Akita Kasei K.K.), Megafac F 171 and F 173 (products of Dainippon Ink & Chemicals), Fluorad FC 430 and FC 431 (products of Sumitomo 3M Limited), Asahi Guard AG 710, Surflon S-382, Surflon SC 101, SC 102, SC 103, SC 104, SC 105 and SC 106 (products of Asahi Glass Co., Ltd.). Use is also made, for example, of the organosiloxane polymer KP 341 (product of Shin-Etsu Chemical Co., Ltd.) and Polyflow No. 75 and No. 95 (products of Kyoeisha Yushikagaku Kogyo K.K.), which are acrylic acid or methacrylic acid polymers. The amount of surfactant used is about 0.01-0.1% by weight, based on the total amount of components (A) and (B).

More strongly basic additives, such as aromatic and aliphatic amines, ammonium salts and N-containing heterocyclic compounds, usually in a concentration of from 0.01 to 1% by weight, based on the total amount of components (A) and (B).

The resist formulations according to the invention are prepared, for example, by mixing components (A), (B) and, if used, (C) and (D), with stirring at room temperature, to give a homogenous solution.

The resist formulation is applied uniformly to the substrate at room temperature by known coating methods, for example by dipping, knife coating, brushing, spraying, especially electrostatic spraying, and reverse roller coating, and in particular by spin coating.

The add-on (layer thickness) and the nature of the substrate are dependent on the desired field of application. The layer-thickness range generally covers values from 0.1 to more than 10 µm, preferably from 0.2 to 2.0 µm.

In microelectronics the substrate is, for example, a surface-oxidized silicon wafer.

After coating, the solvent is generally removed by drying, for example at temperatures of between 70 and 130°C.

The resist film is a photoresist which, after drying, has high sensitivity to actinic radiation and very good adhesion to the substrate. Furthermore, it has high transparency and sensitivity even in the deep UV region, especially at 250 nm, and has good thermal stability.

In order to produce relief structures, the substrate coated with the novel composition is subjected to imagewise exposure. The term "imagewise" exposure covers both exposure through a photomask containing a predetermined pattern, for example a transparency, and exposure with a laser beam which is moved over the surface of the coated substrate, for example under computer control, to generate an image, irradiation with computer-controlled electron beams, and exposure to X-rays or UV radiation through an appropriate mask.

In general, exposure is carried out using UV and/or VIS radiation, preferably having a wavelength of between about 190 and 1000 nm, in particular from 190 to 300 nm, and especially 250 nm. Irradiation can be carried out in principle using all known radiation sources, for example high-pressure mercury lamps or UV/VIS lasers and, in particular, excimer lasers (KrF excimer laser light having a wavelength of 248 nm). The radiation source can also comprise X-rays (for example synchrotron radiation) or beams of charged particles (for example electron beams), inter alia. The process parameters, for example the period of irradiation and the distance of the radiation source from the radiation-sensitive layer, depend generally on the nature of the radiation-sensitive composition and on the desired properties of the coating and can be determined by the person skilled in the art using a few routine experiments.

After imagewise exposure, the wafer may be subjected to a post-exposure bake at 50 to 150°C for a few seconds to a few minutes.

The exposed areas of the photoresist are subsequently washed out with a developer. The choice of particular developer depends on the type of photoresist, in particular on the nature of the binder used or of the photolysis products formed. The developer can comprise aqueous solutions of bases to which, if desired, wetting agents and organic solvents or mixtures thereof are added.

The compositions according to the invention are preferably used as positive resists. The invention therefore additionally relates to a process for the production of positive images which comprises the following process measures:
(I.) coating a substrate with a radiation-sensitive composition comprising, based on the total amount of components (A) and (B),
   (A) from 80 to 99.9% by weight of a phenolic resin according to the invention and
   (B) from 0.1 to 20% by weight of a substance which generates an acid on exposure to actinic radiation, and
(II.) exposing the coated substrate to actinic radiation in a predetermined pattern, and
(III.) developing the exposed substrate with a developer for positive-working resists.

Particularly preferred developers are the aqueous-alkaline solutions also used for the development of o-quinone diazide/novolak resist coatings. These include, for example, aqueous solutions of alkali metal silicates, phosphates, hydroxides and carbonates, but in particular tetraalkylammonium hydroxide solutions, for example tetramethylammonium hydroxide solution. Minor amounts of wetting agents and/or organic solvents may also be added to these solutions. Typical organic solvents which can be added to the developer liquids are, for example, cyclohexanone, 2-ethoxyethanol, acetone, isopropanol, ethanol and mixtures of two or more of these solvents.

The developer is preferably applied by immersing the imagewise exposed coated substrate in the developer solution, spraying the developer solution onto the substrate or repeatedly applying and spin-coating the developer to the coated imagewise exposed substrate, and removing the developer by centrifugation.

The invention additionally relates to the use of the compositions according to the invention as positive resists for the production of printing plates, printed circuits or integrated circuits, and to the printing plates, printed circuits or integrated circuits produced using the compositions according to the invention.

The invention is illustrated by the following non-limitative Examples. All parts and percentages are by weight and temperature are degree Celsius unless explicitly stated otherwise.

### EXAMPLES:

### Synthesis Example 1:

Preparation of monodispersed poly(4-(1-tert-butoxyethoxy)styrene/4-hydroxystyrene). 15.0 g of monodispersed poly-4-hydroxystyrene (Nippon Soda VP-8000: Mw = 8300, Mw/Mn = 1.12) are dissolved in 70 ml of tetrahydrofuran and the solution is stirred at room temperature for 20 h together with 6.2 g of tert-butyl vinyl ether and a catalytic quantity of 4-toluenesulfonic acid. The catalyst is subsequently removed from the reaction solution with a basic ion exchanger. The polymer is subsequently precipitated by charging the reaction solution to water, isolated by filtration, washed with water and then dried to constant weight, giving 15.5 g of poly (4-(1-tert-butoxy ethoxy)styrene/4-hydroxystyrene) in which, according to analysis by TGA, 30 mol% of the OH groups are protected.
- Decomposition temperature:: 210°C (TGA, heating rate 10°C/min)
- GPC:: Mw = 8530, Mw/Mn = 1.18
The polymer is thermally stable: at 120°C no perceptible loss in mass through autocatalytic decomposition is observed.

### Synthesis Example 2:

Preparation of monodispersed poly(4-(1-tert-butoxyethoxy)styrene/4-hydroxystyrene). 15.0 g of monodispersed poly-4-hydroxystyrene (Nippon Soda VP-8000: Mw = 6460, Mw/Mn = 1.18) are dissolved in 70 ml of tetrahydrofuran and the solution is stirred at room temperature for 16 h together with 4.5 g of tert-butyl vinyl ether and a catalytic quantity of hydrochloric acid. The catalyst is subsequently removed from the reaction solution with a basic ion exchanger. The polymer is subsequently precipitated by charging the treated reaction solution to water, isolated by filtration, washed with water and then dried to constant weight, giving 15.4 g of poly(4-(1-tert-butoxy ethoxy)styrene/4-hydroxystyrene) in which, according to analysis by TGA, 30 mol% of the OH groups are protected.
- Decomposition temperature:: 210°C (TGA, heating rate 10°C/min)
- GPC:: Mw = 8390, Mw/Mn = 1.16
The polymer is thermally stable: at 120°C no perceptible loss in mass through autocatalytic decomposition is observed.

### Synthesis Example 3 (comparison):

Preparation of polydispersed poly(4-(1-tert-butoxyethoxy)styrene/4-hydroxystyrene). In general accordance with the procedure of Synthesis Example 1, reaction of 15.0 g of polydispersed poly-4-hydroxystyrene (Hoechst Celanese: Mw = 8560, Mw/Mn = 3.91) and 6.2 g of tert-butyl vinyl ether gives 15.0 g of poly(4-(1-tert-butoxyethoxy)styrene/4-hydroxystyrene) in which, according to analysis by TGA, 30 mol% of the OH groups are protected.
- Decomposition temperature:: 205°C (TGA, heating rate 10°C/min)
- GPC:: Mw = 20 280, Mw/M = 4.5
At 120°C, slow decomposition resulting from autocatalytic deprotection is observed.

### Application Example 1:

98.8 parts by weight of the copolymer prepared in Synthesis Example 1, 1.0 part by weight of phenyl cumyl disulfone and 0.2 part by weight of 4,4'-diaminodiphenyl ether are dissolved in 354 parts of 1-methoxy-2-propyl acetate. The solution is filtered through a filter having a pore diameter of 0.2 µm and is spin-coated onto a silicon wafer such that, after predrying for 60 seconds at 120°C on a hotplate, a film having a thickness of 0.78 µm is obtained. Exposure is carried out with a 5:1 projection exposure unit (Canon FPA 4500, NA 0.37) with KrF excimer laser radiation (248 nm) through a dark field mask in steps of 3 mJ/cm. The wafer is then given a post-exposure bake on the hotplate at 110°C for 60 seconds, and afterwards developed for 60 seconds in commercial 0.262 N tetramethylammonium hydroxide solution.

At an exposure dose of 36 mJ/cm², accurately reproduced, vertical 0.35 µm l/s structures are obtained with resist 1. 0.50 µm contact holes are reproduced with vertical edges.

### Application Example 2:

96.85 parts by weight of the copolymer prepared in Synthesis Example 2, 3.0 parts by weight of 2-nitro-6-trifluoromethylbenzyl 4-methoxybenzenesulfonate and 0.15 part by weight of 2,4,5-triphenylimidazole are dissolved in 354 parts of 1-methoxy-2-propyl acetate. The solution is filtered through a filter having a pore diameter of 0.2 µm and is spin-coated onto a silicon wafer in such a way that, after predrying for 60 seconds at 120°C on a hotplate, a film having a thickness of 0.82 µm is obtained. Exposure is carried out with a 5:1 projection exposure unit (Canon FPA 4500, NA 0.37) with KrF excimer laser radiation (248 nm) through a dark field mask in steps of 3 mJ/cm. The wafer is then given a post-exposure bake on the hotplate at 120°C for 60 seconds, and afterwards developed for 60 seconds in commercial 0,262 N tetramethylammonium hydroxide solution.

At an exposure dose of 25 mJ/cm², accurately reproduced, vertical 0.35 µm l/s structures are obtained.

### Application Example 3 (comparison):

98.8 parts by weight of the copolymer prepared in Synthesis Example 3, 1.0 part by weight of phenyl cumyl disulfone and 0.2 part by weight of 4,4'-diaminodiphenyl ether are dissolved in 354 parts of 1-methoxy-2-propyl acetate (resist solution 2).

The process is carried out under conditions similar to those in Application Example 1.

At an exposure dose of 36 mJ/cm², undesirable T-shaped 0.35 µm structures are observed with resist 2. 0.50 µm contact holes are reproduced with an overhang on the resist surface.

While the invention has been described above with reference to specific embodiments thereof, it is apparent that many changes, modifications, and variations can be made without departing from the inventive concept disclosed herein. Accordingly, it is intended to embrace all such changes, modifications, and variations that fall within the spirit and broad scope of the appended claims.

## Claims

1. A phenolic resin in which 10-90% of the phenolic hydroxyl groups are replaced by protective groups of the formula I: 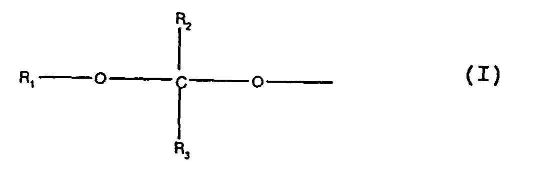 in which R₁ and R₂ are each independently of the other C₁-C₆alkyl, C₃-C₆cycloalkyl which is unsubstituted or is substituted by one or more C₁-C₄alkyl groups, or are -(CH₂)ₙ-aryl, or R₁ and R₂, together with the oxygen and carbon atoms attached to these radicals, form a five- to eight-membered ring which may contain, as ring members, further heteroatoms or hetero-groups such as -O-, -S-, -SO₂-or -NR₈-, where R₈ is C₁-C₆alkyl, aryl or C₆-C₁₆aralkyl, R₃ is hydrogen, C₁-C₆alkyl, C₃-C₆cycloalkyl which is unsubstituted or is substituted by one or more C₁-₄alkyl groups, or is -(CH₂)ₙ-aryl, or R₂ and R₃, together with the carbon atom attached to these radicals, form a five- to eight-membered ring which may contain, as ring members, further heteroatoms or hetero-groups such as -O-, -S-, -SO₂- or -NR₈-, where R₈ is C₁-C₆alkyl, aryl or C₆-C₁₆aralkyl, n is 0, 1, 2 or 3 and aryl is naphthyl or phenyl which is substituted by one or more C₁-C₄alkyl, C₁-C₄alkoxy, nitro or cyano groups or halogen atoms, with the proviso that the ratio of the weight-average to the number-average molecular weight, M_{w}/Mₙ, is in the range of 1.03-1.80.

2. A phenolic resin according to claim 1, containing structural repeating units of the formulae II and III: 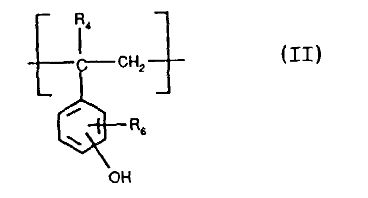 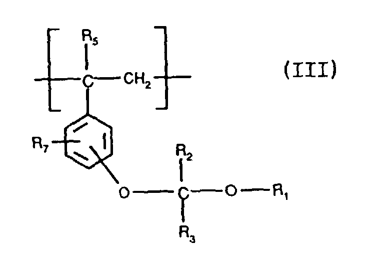 in which R₁, R₂ and R₃ are as defined in claim 1 and R₄ and R₅ are each independently of the other hydrogen, methyl or halogen, and R₆ and R₇ are each independently of the other hydrogen, C₁-C₄alkyl, C₁-C₄alkoxy or halogen.

3. A phenolic resin according to claim 2, containing structural repeating units of the formulae IIa and IIIa: 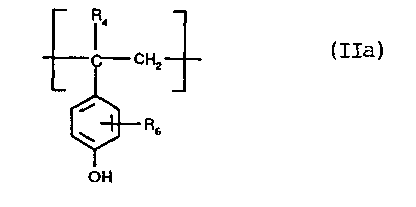 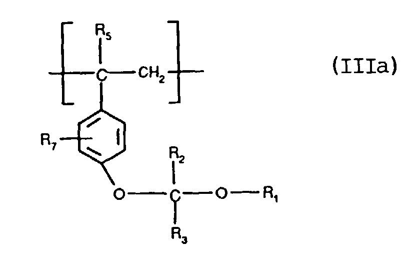 in which R₁ to R₇ are as defined in claim 2.

4. A phenolic resin according to claim 2, containing structural repeating units of the formulae II and III, in which R₄, R₅, R₆ and R₇ are hydrogen.

5. A phenolic resin according to claim 2, containing structural repeating units of formulae II and III, in which R₁ and R₂ are each independently of the other methyl, ethyl, n-propyl, isopropyl, n-butyl, isobutyl, tert-butyl, or cyclohexyl or R₁ and R₂, together with the linking oxygen and carbon atoms, form a tetrahydropyranyl ring.

6. A phenolic resin according to claim 2, containing structural repeating units of the formulae II and III in which R₃ is hydrogen or methyl.

7. A phenolic resin according to claim 1 in which 15-70% of the phenolic hydroxyl groups are replaced with protective groups of the formula I.

8. A phenolic resin according to claim 1, wherein the ratio of the weight-average to the number-average molecular weight, M_{w}/Mₙ, is 1.03-1.5.

9. A radiation-sensitive composition comprising, based on the total amount of components (A) and (B),
(A) 80.0-99.9% by weight of phenolic resin according to claim 1 and
(B) 0.1-20.0% by weight of a substance which generates an acid on exposure to actinic radiation.

10. A radiation-sensitive composition according to claim 9, composing in addition to components (A) and (B) an organic solvent as component (C).

11. A radiation-sensitive composition according to claim 9, wherein as component (B) is a disulfone or a sulfonic acid ester.

12. A process for producing positive images by
(I.) coating a substrate with a radiation-sensitive composition according to claim 9,
(II.) exposing the coated substrate to actinic radiation in a predetermined pattern, and
(III.) developing the exposed substrate with a developer for positive-working resists.

13. The use of a radiation-sensitive composition according to claim 9 as a positive resist for the production of printing plates, printed circuits or integrated circuits.

14. A printing plate, printed circuit or integrated circuit produced with a radiation-sensitive composition according to claim 9.
